# EUROPEAN PATENT APPLICATION

(11) **EP 2 302 669 A1**
(43) Date of publication of application: **30.03.2011**
(21) Application number: 11150596.2
(22) Date of filing: 04.11.2005
(51) Int. Cl.: H01L 21/56, H01L 23/29

(54) **Encapsulation material for integrated circuits containing carbon nanotubes**

(30) Priority: 04.11.2004 US 625452 P
(62) Divisional of application: 05800507.5
(71) Applicant: Taiwan Semiconductor Manufacturing Co., Ltd., Science-Based Industrial Park Hsin-Chu, 300-77 (TW)
(72) Inventor: Wyland, Chris, San Jose, CA 95131 (US); Thoonen, Hendrikus Johannes Jocabus, San Jose, CA 95131-1706 (US)
(74) Representative: van Westenbrugge, Andries

(57) **Abstract**

A variety of characteristics of an integrated circuit chip arrangement with a chip and package-type substrate are facilitated. In various example embodiments, a carbon nanotube-filled material (110) is used in an arrangement between an integrated circuit chip (220, 340) and a package-type substrate (210, 350). The carbon-nanotube filled material is used in a variety of applications, such as package encapsulation (as a mold compound (330)), die attachment (374) and flip-chip underfill (240). The carbon nanotubes facilitate a variety of characteristics such as strength, thermal conductivity, electrical conductivity, durability and flow.

## Description

The present invention is directed to integrated circuit devices and approaches and, more particularly, to integrated circuit mold or attachment filler employing nanotube material.

Filler material for integrated circuit chip applications such as mold compounds and underfill plays an important role in the manufacture and implementation of circuits. For example, integrated circuits, flip-chip type circuits and others are often mounted upon a substrate, with a mold type material encapsulating the circuits on the substrate. With certain applications, filler material is used as an underfill, below circuits (e.g., chips), in and around circuit connections such as solder ball type connectors. The filler material, either in an encapsulating mold type application or underfill application, acts to secure circuits and/or chips in place. In addition, the filler material can be used to electrically insulate certain circuits and connectors.

A variety of filler materials have been used for these purposes. Silica is one type of filler material used for both underfill and mold compounds. The silica is typically mixed in another material, such as an epoxy, and gives the material characteristics desirable for applications with integrated circuits and packages, such as strength for supporting such circuits and packages. Another type of filler material is silver. The silver is also typically mixed with epoxy, and often is used to attaché a die to a package.

In many circuit applications, managing heat generated by the circuits is important. As integrated circuit devices become smaller, circuits are packed closer together and, thus, a significant amount of current passes through small areas. Increased density and/or power consumption generally leads to increased heat generation, which can pose potential problems for circuit components.

The thermal conductivity of filler materials and applications with mold compounds, underfill material (between a chip and package) and with die attaching materials has an impact on the removal of heat from circuits in the chip and package, as well as circuits connecting the two. Silica has a typically low thermal conductivity relative, e.g., to electrically conductive materials such as metals. With these characteristics, adequately removing heat from circuits employing packaging materials using silica filler is challenging.

In some instances, the inadequate removal of heat can lead to longevity and performance issues. As integrated circuit devices are manufactured with higher density, this problem is exacerbated. Further, as higher performance from integrated circuits is required, performance fluctuations relating to thermal issues can lead to performance issues.

These and other difficulties present challenges to the implementation of circuit substrates for a variety of applications.

Various aspects of the present invention involve substrates and/or packaging that can be implemented with integrated circuits and other devices. The present invention is exemplified in a number of implementations and applications, some of which are summarized below.

Various applications of the invention are directed to carbon-nanotube enhanced integrated circuit chip package arrangements. In many example embodiments, material enhanced with carbon nanotubes is implemented to facilitate an arrangement and relationship between a supporting substrate and an integrated circuit chip.

According to an example embodiment, an integrated circuit interface-type material includes carbon nanotubes. The interface-type material facilitates the structural support of the integrated circuit chip in an arrangement with the supporting substrate.

In another example embodiment of the present invention, an integrated circuit chip arrangement includes a carbon nanotube-enhanced mold compound. An integrated circuit chip is coupled to a supporting substrate. The mold compound is generally over the integrated circuit chip and a portion of the supporting substrate. In some applications, the mold compound substantially encapsulates the integrated circuit chip and electrical connections between the chip and the supporting substrate or other components. Carbon nanotube material in the mold compound facilitates the transfer of heat from the integrated circuit chip and/or electrical connections therewith.

In another example embodiment of the present invention, an integrated circuit chip arrangement includes carbon nanotube-enhanced underfill material. An integrated circuit chip is coupled to a supporting substrate via electrical conductors between the integrated circuit chip and the supporting substrate. The carbon nanotube-enhanced underfill material is flowed between the integrated circuit chip and the substrate, generally surrounding and supporting the electrical conductors. Carbon nanotube material in the underfill material facilitates the transfer of heat from the conductors and/or the integrated circuit chip and/or the supporting substrate.

A carbon nanotube-enhanced bond material is used to secure an integrated circuit chip to a supporting substrate, in connection with another example embodiment of the present invention. The bond material is formed between the integrated circuit chip and the supporting substrate, and physically couples the two. Carbon nanotube material in the bond material facilitates the transfer of heat from the integrated circuit chip, the supporting substrate and/or connectors therebetween. In one implementation, the bond material has a concentration of carbon nanotube material that is sufficient to make the bond material electrically conductive.

The above summary of the present invention is not intended to describe each illustrated embodiment or every implementation of the present invention. The figures and detailed description that follow more particularly exemplify these embodiments.

The invention may be more completely understood in consideration of the following detailed description of various embodiments of the invention in connection with the accompanying drawings, in which:
FIG. 1A shows a cut-away view of a substrate-type material with carbon nanotube filler, according to an example embodiment of the present invention;
FIG. 1B shows a cut-away view of a substrate-type material with carbon nanotube and silica filler, according to another example embodiment of the present invention;
FIG. 2 shows a flip-chip device with a carbon nanotube underfill material, according to another example embodiment of the present invention; and
FIG. 3 shows an integrated circuit device with a BGA-type substrate and an integrated circuit chip coupled thereto, according to another example embodiment of the present invention.

While the invention is amenable to various modifications and alternative forms, specifics thereof have been shown by way of example in the drawings and will be described in detail. It should be understood, however, that the intention is not to limit the invention to the particular embodiments described. On the contrary, the intention is to cover all modifications, equivalents, and alternatives falling within the scope of the invention as defmed by the appended claims.

The present invention is believed to be applicable to a variety of circuits and approaches involving and/or benefiting from package materials, and in particular, from packaging materials such as mold or filler material used with chip-package arrangements. While the present invention is not necessarily limited to such applications, an appreciation of various aspects of the invention is best gained through a discussion of examples in such an environment.

According to an example embodiment of the present invention, a carbon nanotube-type filler material is implemented with an integrated circuit chip package arrangement. Various applications involve securing an integrated circuit chip to a package type substrate. Other applications involve interfacing (without necessarily securing) between circuits, such as between a chip and package substrate. Still other applications involve both securing a chip to a package type substrate and interfacing between the chip and the substrate.

In another example embodiment, a mold-type carbon nanotube compound is used over and/or to encapsulate an integrated circuit chip on a package substrate. The integrated circuit chip is typically arranged on the package substrate, with circuits connecting the chip to the package for passing signals (i.e., inputs and outputs) therebetween. The mold-type carbon nanotube compound is formed over the integrated circuit chip and connecting circuits (e.g., bondwire, solder balls and/or leadframe), and electrically insulates the chip and any connectors from each other. The carbon nanotubes in the mold facilitate the transfer of heat away from the integrated circuit chip and/or the package substrate to which it is mounted.

In another example embodiment, an integrated circuit package interface material includes carbon nanotube filler. The interface material is adapted for filling voids between the integrated circuit chip and the package type substrate when coupled together. In some applications, the interface material fills areas around circuit connections between the integrated circuit chip and package substrate, such as around solder bumps implemented with a flip-chip type applications. The carbon-nanotube type material is implemented to conduct heat generated by the integrated circuit chip (or chips) implemented with the material.

In one application, the interface material is an underfill material configured for flowing between the integrated circuit chip and the package substrate. Carbon nanotubes are mixed throughout the underfill material, which is selected to achieve flow characteristics that facilitate the filling of voids around circuit connectors between the chip and package. The underfill material may be implemented, for example, with materials previously used in underfill applications. The nanotubes flow with the underfill material into the voids and facilitate the heat transfer away from the circuit connectors and, depending upon the arrangement, away from the chip and/or package.

In another example embodiment, carbon nanotubes are used to support, or stiffen, substrate-type materials used with the integrated circuit chips as discussed above. The carbon nanotube-stiffened material is arranged to secure the integrated circuit chip with the package substrate, such as by forming a securing interface between the integrated circuit chip and the package substrate or by encapsulating the package substrate.

In some applications, the carbon nanotube-stiffened material provides substantial support for maintaining an arrangement between the integrated circuit chip and the package substrate. For example, the carbon nanotube-stiffened material can be arranged to provide the majority of physical support holding the integrated circuit chip in place, relative to the package substrate. In other applications, the carbon nanotube-stiffened material provides over 75% of physical support holding the integrated circuit chip in place. In these applications, the physical support can be related to the ability of the carbon nanotube-stiffened material to maintain the integrated circuit chip in connection with the package substrate (i.e., without the material, the chip would move relative to the package under slight pressure).

In another example embodiment, a mold-type material with carbon nanotube filler is selectively placed adjacent to heat-generating components such as circuits, circuit components, integrated circuit chips and connecting circuits. Generally, the mold-type material can be implemented with one or more of encapsulating mold compounds, underfill material and die attaching material. The mold-type material conducts thermal energy generated by the heat-generating components. The mold-type material is implemented in packaging for the circuit substrate, such as with the substrate itself and/or with others portions of a package, such as with material used to bond circuit package components together, to encapsulate chips or to fill voids between circuit components. In some applications, the mold-type material is arranged to conduct heat away from a particular circuit. In other applications, the mold-type material is arranged to generally dissipate heat evenly in a particular layer or substrate.

A variety of types of carbon nanotube material can be used in the various applications discussed herein, and is mixed with other materials in particular applications to suit selected needs. For example, carbon nanotube dust, multi-walled and single-walled carbon nanotubes, and other carbon-nanotube based materials are used for different applications. These carbon nanotube materials are generally small; i.e., smaller than silica or other common filler material.

In addition, the type of carbon nanotube material can be selected to specifically address application needs, such as stiffness, strength, thermal conductivity, electrical conductivity (or lack thereof) and the ability to mix the material with other materials, such as epoxy or resin. For example, where the carbon nanotube material and the material in which it is mixed needs to flow, such as in underfill applications, the size of the carbon nanotube material is desirably small to facilitate flow. In this regard, small-size carbon nanotube dust is readily mixed into underfill type materials. Correspondingly, the type of material in which the carbon nanotube material is mixed to achieve various characteristics s such as strength, durability and flammability.

In various support and/or thermal dissipation embodiments, the carbon nanotubes are oriented in particular directions to facilitate specific supporting or thermal dissipating needs. In some applications, carbon nanotube material is randomly or uniformly mixed throughout a mold-type material such as epoxy or plastic. In other applications, carbon nanotubes are arranged in a particular orientation for achieving certain stiffness and/or strength for supporting applications.

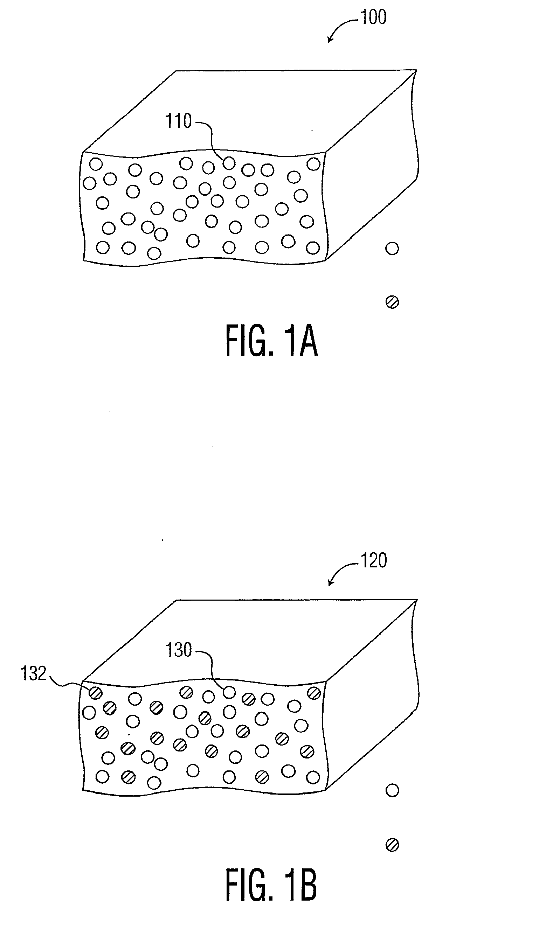

Turning now to the figures, FIG. 1A shows a cut-away view of a substrate-type material 100 with carbon nanotube filler, according to an example embodiment of the present invention. The carbon nanotube filler is shown as small circles in the substrate-type material 100, with representative filler material labeled 110. While shown as circles by way of example, the filler material can be implemented with a variety of types of carbon nanotube material, such as dust and single and/or multi-walled carbon nanotubes. Further, the shown arrangement is also by way of example, with a variety of approaches to arrangement and placement of the carbon nanotube filler applicable to this example embodiment. In this regard, the shown shape and arrangement of the nanotube filler in FIG. 1A, as well as in FIG. 1B as discussed below, is for purposes of example and encompasses a variety of shapes and arrangements.

FIG. 1B shows a cut-away view of a substrate-type material 120 with carbon nanotube and silica filler, according to another example embodiment of the present invention. The substrate-type material 120 is similar to the material 100 in FIG. 1A, with silica filer in addition to carbon nanotube filler. Small clear circles are used to show an example representation of the carbon nanotube filler, similar to that shown in FIG. 1A, with representative carbon nanotube filler labeled 130. Small hatched circles are used to show an example representation of the silica filler, with representative silica filler labeled 132.

The substrate-type materials 100 in FIG. 1A and 120 in FIG. 1B can be implemented in a variety of applications, such as with encapsulating mold compounds, die attach material and underfill. In this regard, the materials 100 and 120 can be implemented with various examples described herein, including with the figures discussed below.

The concentration of carbon nanotube filler (130) and/or silica filler (132) in the substrate-type material 100 and 120 respectively shown in FIGs. 1A and 1B is selected to meet various conditions. For instance, the concentration of carbon nanotube filler is relatively high for applications in which high heat transfer is desired and electrical conductivity is tolerated. In applications where the substrate-type material cannot be electrically conductive (e.g., in an underfill application), the concentration of nanotube filler is kept sufficiently low to inhibit electrical conductivity. For general information regarding filler applications and for specific information regarding conductivity as relating to filler concentration as may be implemented in connection with this and/or other example embodiments discussed herein, reference may be made to Patrick Collins and John Hagerstrom, "Creating High Performance Conductive Composites with Carbon Nanotubes, which is fully incorporated herein by reference.

In one implementation, electrical conductivity is inhibited by establishing the concentration of carbon nanotube filler material (110 in FIG. 1A, 130 in FIG. 1B) sufficiently low. This carbon nanotube filler concentration is controlled relative to the composition of the substrate-type material and, in the instance of FIG. 1B, silica (or other) filler material. For instance, where the substrate-type material is generally electrically insulative, a higher concentration of carbon nanotube material can be implemented while maintaining the overall substrate material in a generally non-conductive arrangement.

The concentration of carbon nanotube material can be implemented independent from, or relative to, other filler material such as silica. For instance, in some applications, a particular amount of combined filler is maintained, with the concentration of carbon nanotube filler being selected relative to silica filler (e.g., less carbon nanotube filler means more silica filler). Raising or lowering the concentration of carbon nanotube filler, relative to silica filler, correspondingly raises or lowers the conductivity of the substrate-type material in which the filler is implemented.

The material used for the substrate-type material 100 or 120 in Figs. 1A and 1B respectively (surrounding the filler) is selected to meet the needs of particular applications. For instance, where the substrate-type material needs to support an integrated circuit chip, such as by securing the chip to a package, the material is selected for achieving adhesive-type characteristics. Where the substrate-type material needs to flow, the material is selected for flow properties. For applications benefiting from strong connections, and epoxy-type material can be used. In applications benefiting from a less strong, or a soft attachment, a low-temperature thermoplastic material can be used.

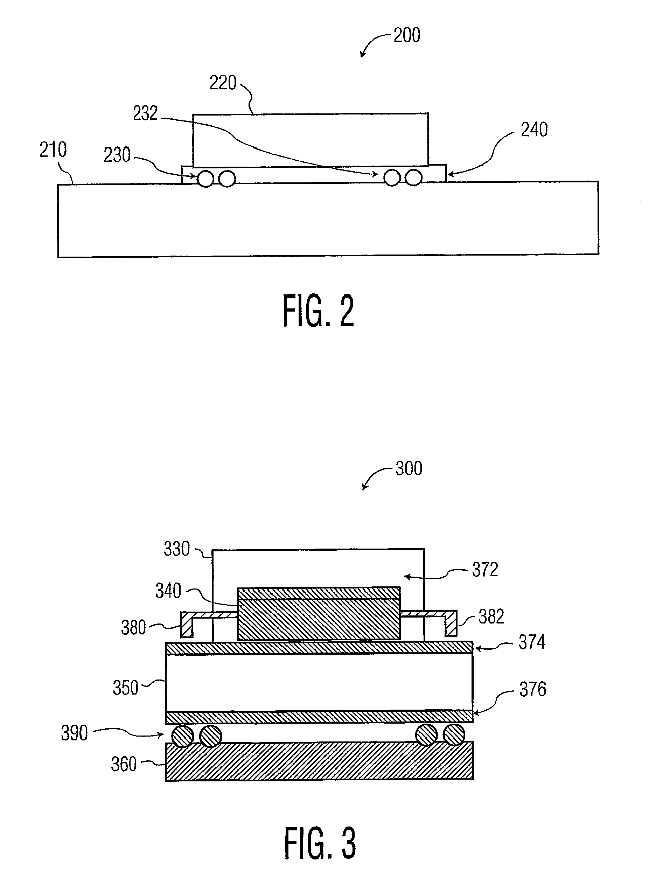

FIG. 2 shows a flip-chip device 200 employing a carbon nanotube filler material, according to another example embodiment of the present invention. The flip-chip device 200 includes an integrated circuit chip 220 (flip-chip) inverted, or flipped, circuit-side down onto a package substrate 210. This approach, relative to conventionally-oriented chips with a circuit side up, brings the circuits in the flip-chip 220 closer to connections to the package substrate 210, reducing the length of connecting circuits and, correspondingly, facilitating an increase in the speed of the device 200.

Connecting the flip-chip 220 and the package substrate 210 is a series of connectors including representative conventional solder ball connectors at opposite ends of the flip-chip 220 and respectively labeled 230 and 232. An underfill material 240 is located between the flip-chip 220 and the package substrate 210, filling voids around the connectors including those labeled 230 and 232.

The underfill material 240 helps to seal connections between the flip-chip 220 and the package substrate 210, as well as to seal any circuit interfaces (e.g., pads) on the flip-chip and package substrates themselves. In this regard, the underfill material 240 is electrically non-conductive to the extent needed to inhibit electrical conduction between conductive circuits between the flip-chip 220 and the package substrate 210.

The carbon nanotube filler material in the underfill material 240 is implemented at particular concentration with a material such as epoxy in a manner that maintains the underfill in a generally non-conductive state. The carbon nanotube filler material is mixed, e.g., as shown in FIGs. 1A and/or 1B. With this approach, the carbon nanotube filler material enhances the thermal conductivity of the underfill material 240 while maintaining generally non-conductive characteristics with the underfill.

In one implementation, connectors (including solder balls 230 and 232) are coated or otherwise arranged with an electrically insulative material such as an oxide, which separates and electrically insulates the connectors from the underfill material 240. The carbon nanotube material in the underfill 240 is thus less likely to conduct electricity from insulated circuit components. In some instances, the insulative material sufficiently insulates circuits from the underfill such that the underfill is made with a relatively high concentration of carbon nanotube material that makes the underfill electrically conductive.

In another implementation, the underfill material 240 is adapted for supporting circuit connectors including representative conventional solder ball connectors 230 and 232. The structural support by the underfill material 240 (with carbon nanotube filler) counters stresses upon the circuit connectors and helps to prevent cracking and other damage. For instance, where thermal expansion coefficients of the flip-chip 220 and the package substrate 210 differ, stresses can be places upon circuit connectors as the operational temperature of the flip-chip device 200 changes. Under high temperature operation, thermal stresses can cause the circuit connectors to crack, without the support of the underfill material. In this regard, the underfill material 240 is strengthened with the carbon nanotube filler to mitigate (e.g., counter or prevent) thermal-induced stress cracking.

FIG. 3 shows an integrated circuit device 300 employing a carbon nanotube-filled mold compound, according to another example embodiment of the present invention. The device 300 includes a BGA-type substrate 350 with an integrated circuit chip 340 arranged on the substrate. The BGA-type substrate is in turn coupled to external circuits via arrangement 360, with a series 390 of solder ball connectors. A mold compound 330 having carbon nanotube filler secures the integrated circuit chip 340 to the BGA-type substrate 350 and, via the carbon nanotube filler, facilitates heat transfer from the integrated circuit chip, substrate and electrical connections therewith. The mold compound further seals and/or protects electrical connections between the integrated circuit chip 340 and the BGA-type substrate 350, with representative connectors 380 and 382 shown by way of example.

An optional carbon nanotube-filled interface material is added at selected interfaces in the device 300. By way of example, interface regions 372 (between the integrated circuit chip and the mold compound 330), 374 (between the integrated circuit chip and the BGA-type substrate 350) and 376 (between the BGA-type substrate and external circuit arrangement 360) are shown. These interface materials facilitate heat-spreading within the interface material as well as the conduction of thermal energy away from the device 300. Other interface type applications, in conjunction with or separate from the shown regions 372, 374 and 376 such as the underfill approach described with FIG. 1, are optionally implemented with the device 300. For example, an underfill-type approach can be implemented with the region 376 between the BGA-type substrate and the external circuit arrangement 360, filing voids around the series 390 of solder ball connectors.

The carbon nanotube-filled interface material at region 374 is optionally implemented as a die attach compound, with the material physically securing the integrated circuit chip 340 (die) to the BGA-type substrate 350. The material used, with the carbon-nanotube filler, in region 374 is thus structurally stiff and couples to both the integrated circuit chip 340 and the BGA-type substrate 350.

The carbon nanotube filler composition and arrangement in the mold compound 330 is selected to meet various application needs. To meet these needs, the carbon nanotube filler can be mixed in the mold compound 330 and/or combined with other filler material such as shown in FIGs. 1A and/or 1B. In one implementation, the concentration of carbon nanotube filler in the mold compound 330 is sufficient to enhance electrical conductivity in the mold compound. Portions of the mold compound 330 adjacent conductive circuits are insulated. The relatively high concentration of carbon nanotube filler required to make the mold compound conductive also facilitates thermal conductivity and, correspondingly, the removal of heat from the device 300.

In one application, the carbon nanotube filler concentration of the mold compound 330 is sufficiently high to promote conductivity in a manner that facilitates a "transmission line effect" in the mold compound (similar, e.g., to transmission line effects typically associated with a coaxial cable). Such a sufficient concentration is relative to characteristics of the particular application, such as thickness of the mold compound, strength of any relative electric fields and proximity of circuitry. An electrical field is generated relative to the conductive mold compound 330 and is used with the integrated circuit chip 340 for a variety of purposes. For instance, current passed in the mold compound 330 causes an interaction with current in the integrated circuit chip 340, in accordance with characteristics such as the amount of current passed, location of the carbon nanotube filler and frequency of the current. These characteristics are thus selected to meet desirable interactions for each particular application, for example, such that any generated electrical field causes characteristic reactions in adjacent circuitry.

The bulk material for the mold compound 330 (the material that holds the carbon nanotube filler) is selected to meet application needs, such as those relating to thermal or electrical conductivity, as well as physical needs relating to strength, durability and flammability. Materials such as epoxy, Bi-phenyls and other plastics are examples used for various applications.

In various applications, manufacturing-related characteristics of the bulk material with carbon nanotube filler are selected to address other challenges such as bondwire deformation (sweep) and others relating to stresses under which the device 300 is placed. For instance, the size of the carbon nanotube filler material is maintained generally small to facilitate flow of the mold compound 330 around circuit connectors, such as connectors 380 and 382.

In another example embodiment of the present invention, a mold compound is implemented with a compound material with carbon nanotube filler concentration that is intrinsically ESD (electrostatic discharge) protected. Using FIG. 3 as an example, the integrated circuit chip 340 is encapsulated by an insulative compound with the mold compound 330 and/or coated with a carbon nanotube-including plastic. The mold compound (and carbon nanotube coating, if applicable) is substantially devoid of magnetic particles, which minimizes polar inductive interaction with the coating. The mold compound (or carbon nanotube coating) facilitates relatively small current leakage when the device 300 in operation. This approach is applicable to a variety of devices, with the description here in connection with FIG. 3 being an particular example. Other applications_{;} including those with which the arrangements in FIGs. 1A and 1B apply, are readily implemented with this approach.

The various embodiments described above and shown in the figures are provided by way of illustration only and should not be construed to limit the invention. Based on the above discussion and illustrations, those skilled in the art will readily recognize that various modifications and changes may be made to the present invention without strictly following the exemplary embodiments and applications illustrated and described herein. For example, the carbon nanotubes may be implemented with material different from, or in addition, to, carbon, such as Boron. As another example, filler material having characteristics similar to that of carbon nanotubes (e.g., material having thermal conductivity near 3000W/mK and thermal expansion coefficient of about 0.25ppm) can be used in place of, or in addition to, the carbon nanotube filler. In addition, the substrate-type materials discussed by way of example may be implemented with a multitude of different types of materials, used alone and/or in conjunction with one another or with the above-described materials. Such modifications and changes do not depart from the true spirit and scope of the present invention.

## Claims

1. An integrated circuit chip arrangement (300) comprising:
a supporting substrate (350);
an integrated circuit chip (340) coupled to the supporting substrate; and
a mold compound material (330) over the integrated circuit chip and at least a portion of the substrate, the mold compound material including carbon nanotube material that facilitates the structural support of the integrated circuit chip in an arrangement with the supporting substrate.

2. The arrangement of claim 1, wherein the mold compound material includes carbon nanotube filler mixed in a mold substrate.

3. The arrangement of claim 2, wherein the carbonnanotube filler is carbon nanotube dust.

4. The arrangement of claim 2, wherein the carbon nanotube filler has a concentration in the mold substrate that, together with the mold substrate, is substantially non-conductive.

5. The arrangement of claim 4, wherein the mold compound is arranged to inhibit the conduction of electricity from the integrated circuit chip and electrical connections thereto.

6. The arrangement of claim 1, wherein the mold compound includes a relatively lower concentration of carbon nanotube material in a non-conductive region of the mold compound that is immediately adjacent conductive portions of the integrated circuit chip and a relatively higher concentration of carbon nanotube material in a conductive region of the mold compound that is separated from the conductive portions of the integrated circuit chip by the non-conductive region.

7. The arrangement of claim 1, wherein the mold compound includes a filler material mixed in a mold material, the filler material including silica and carbon nanotube filler material, the ratio of carbon nanotube to silica filler being below a threshold ration at which the mold compound would be electrically conductive.

8. The arrangement of claim 1, further comprising: an electrically insulating material arranged to electrically insulate electrical conductors of the integrated circuit chip from the mold compound material; and wherein the carbon nanotube material is of a sufficient concentration in the mold compound material to conduct electricity in the mold compound and to cause a transmission line effect with the integrated circuit chip.

9. The arrangement of claim 1, wherein the supporting substrate is a BGA type substrate.

10. The arrangement of claim 9, wherein the BGA type substrate is in turn coupled to external circuits via an external circuit arrangement with a series of solder ball connectors.

11. The arrangement of claim 1, wherein the mold compound material further seals and protects electrical connections between the integrated circuit chip and the supporting substrate with representative connectors.

12. The arrangement of claim 1, further comprising a first nanotube filled interface material at a first interface between the supporting substrate and the integrated circuit chip.

13. The arrangement of claim 10, further comprising a second nanotube filled interface material at a second interface between the supporting substrate and the external circuit arrangement.

14. The arrangement of claim 1, wherein a bulk material of the mold compound material comprises epoxy, Bi-phenyls and other plastics.

15. The arrangement of claim 1, where the mold compound material is implemented with a compound material with concentration of the carbon nanotube material that is intrinsically ESD (electrostatic discharge) protected.
